# EUROPEAN PATENT APPLICATION

(11) **EP 2 918 701 A1**
(43) Date of publication of application: **16.09.2015**
(21) Application number: 14159964.7
(22) Date of filing: 14.03.2014
(51) Int. Cl.: C23C 16/40, C23C 16/455, H01L 51/52, H01L 51/56

(54) **Method of manufacturing a stacked organic light emitting diode, stacked OLED device, and apparatus for manufacturing thereof**

(71) Applicant: Nederlandse Organisatie voor toegepast- natuurwetenschappelijk onderzoek TNO, 2595 DA 's-Gravenhage (NL)
(72) Inventor: Wilson, Joanne Sarah, 2628 VK Delft (NL); Levell, Jack William, 2628 VK Delft (NL)
(74) Representative: Jansen, Cornelis Marinus

(57) **Abstract**

The invention is directed at a method of manufacturing a stacked organic light emitting diode - OLED - device. The method comprises the steps of providing a carrier (8) and forming a first organic light emitting diode (9) on the carrier by means of solution based depositing of consecutive diode layers of said first organic light emitting diode. The method further comprises forming one or more charge injection layers (12, 14) on the first organic light emitting diode and forming a second organic light emitting diode (16) on the carrier by means of solution based depositing of consecutive diode layers of said second organic light emitting diode. The step of forming of the one or more charge injection layers comprises a step of performing atomic layer deposition for depositing at least one of the one or more charge injection layers. The invention further relates to an apparatus for manufacturing a stacked OLED and to a stacked OLED device.

## Description

### Field of the invention

The present invention is directed at a method of manufacturing a stacked organic light emitting diode - OLED - device. The invention further relates to an apparatus for manufacturing a stacked OLED and to a stacked OLED device.

### Background

Although previously, the OLED lighting standard was at a relatively low brightness level, the industry is presently moving to higher brightness standards. There are various reasons for this, for example, to reduce the required area for a given standard of illumination (office lighting should deliver 500 lm/m2). Another reason is the increased field of application demanding higher brightness levels for certain applications.

Driving OLEDs to high brightness requires high current power supplies complicating driving electronics and power distribution and markedly degrades lifetime. In addition, making single layer white devices requires stack design compromises in order to accommodate multiple emissive species which can reduce efficiency and lifetime. Even if successful, this may still not meet the more stringent spectral requirements of some applications, such as obtaining a desired colour gamut of an OLED display screen.

Stacking OLEDs, often with emission colours, on top of one another is a well-established technique for evaporated OLEDs to address these issues. The OLEDs are connected together by charge generation layers which interconvert electrons and holes using either doped or metallic layers. These layers often take the form of a metal oxide hole injection layer in conjunction with an n-doped electron transport layer.

A common technique to produce stacked OLED devices is by means of thermal evaporation of the consecutive layers. A disadvantage of such evaporation methods is that they are to be carried out in a high vacuum. Moreover, thermal evaporation has limited throughput due to low material deposition rates, requires precise temperature control, and contamination may occur from refractory metals that alloy with the evaporation materials.

### Summary of the invention

It is an object of the present invention to provide overcome the disadvantageous of the prior art manufacturing techniques mentioned above, and to provide a method of manufacturing a stacked organic light emitting diode that can be performed quickly and which may be easily industrialized.

To this end, there is provided herewith a method of manufacturing a stacked organic light emitting diode (OLED) device, comprising the steps of: providing a carrier; forming a first organic light emitting diode on the carrier by means of solution printing of consecutive diode layers of said first organic light emitting diode; forming one or more charge injection layers on the first organic light emitting diode; forming a second organic light emitting diode on the carrier by means of solution printing of consecutive diode layers of said second organic light emitting diode; wherein the step of forming of the one or more charge injection layers comprises a step of performing atomic layer deposition for depositing at least one of the one or more charge injection layers.

The invention is based on the insight that by using solution printing or solution coating to create the various OLED devices that are to be stacked, the stacked OLED devices may be manufactured under atmospheric pressure conditions. This greatly increases the possibilities of industrializing the method of manufacturing, making it available on a much larger scale for many applications. Although hereinafter reference is made sometimes to solution printing and sometimes to solution coating as a solution based depositing method, it is herewith noted that in most cases either one of these methods can be equally applied instead of the other. The more general term used occasionally herein refers to 'solution based depositing' and includes both options.

In addition, the step of forming the one or more charge injection layers comprises at least one step of atomic layer deposition (ALD). This technique may also be applied at atmospheric pressure conditions, and further allows precise control the layer thickness of the layer deposited. Moreover, the combination of consecutive solution printing steps and an atomic layer deposition step in between enables the protection of the layers underneath the ALD layer from being damaged by a solvent that is used for performing the solution printing step for the second OLED device. This is because ALD allows the use of materials for the charge injection layers that are insoluble to solvents used for solution printing. These materials include but are not limited to: zinc oxide (ZnOₓ), titanium oxide (TiOₓ), aluminum zinc oxide (AlZnₓO_{y}), lithium zinc oxide (ZnLiₓO_{y}), magnesium zinc oxide (ZnMgyOₓ), lithium titanium oxide (TiLiₓO_{y}), magnesium titanium oxide (TiMg_{y}Oₓ), magnesium potassium titanium oxide (TiMgₓK_{y}O_{z}), nickel oxide (NiOₓ), tungsten oxide (WOₓ) and molybdenum oxide (MoOₓ) in all possible atomic ratios.

Preferably, the atomic layer deposition step to be performed is a fast atomic layer deposition method. Fast atomic layer deposition is a method of performing atomic layer deposition by relatively moving a substrate or carrier subsequently past one or more precursor or reactor gas sources for performing the atomic layer deposition method in a fast and efficient manner. The technique of fast atomic layer deposition is for example described in WO 2010/024671. In fast atomic layer deposition technique (fast ALD), sometimes referred to as spatial ALD, the precursors are dosed simultaneously and continuously, but at different half-reaction zones. The substrate moves between these zones where the half-reactions take place. The fast ALD steps described may also be applied as a roll-to-roll process, further increasing the performance and yield of the manufacturing method and highly suitable for industrialization.

The fast atomic layer deposition method as described above, in combination with the solution printing method for providing the first OLED device and the second OLED device, provides a very efficient and fast manner of manufacturing the stacked OLED device in accordance with the invention. The ALD deposited charge injection layer enables the formation of a protective layer between the first OLED device and the second OLED device by a suitable choice of materials. The solvent from the second OLED device layer in that case may not damage the first OLED device during manufacturing, because the first device layer is covered by the protective ALD deposited charge injection layer during manufacturing.

As will be appreciated, each of the first and the second (and any further) organic light emitting diode is a multilayer device. The second and further OLED devices are formed on top of the previous OLED devices, separated by means of the charge injection layers being formed comprising at least one atomic layer deposition step. Of course, since both solution printing and atomic layer deposition may be performed under atmospheric conditions, any of the other layers may be formed using ALD as well.

The step of forming the one or more charge injection layers comprises, in accordance with an embodiment, at least one of a step of forming an electron injection layer or a step of forming a hole injection layer. Any one or more of these steps of forming the electron injection layer or the hole injection layer, or both steps, may be performed using an atomic layer deposition step. The use of atomic layer deposition allows the application of different materials than by means of solution printing. In case not all of the one or more charge injection layers is created by means of atomic layer deposition, the use of solution printing for providing the other of the one or more charge injection layers would provide a complementary alternative that allows the deposition of suitable materials.

An electron injection layer as mentioned above may comprise at least one of the group comprising an n-doped material layer comprising a dopant such as an amine, a conjugated organic dopant, a metal salt or a low workfunction metal such as cesium, lithium or magnesium; a metal oxide such as zinc oxide (ZnOₓ), titanium oxide (TiOₓ), aluminum zinc oxide (AlZnₓO_{y}), lithium zinc oxide (ZnLiₓO_{y}), magnesium zinc oxide (ZnMg_{y}Oₓ), lithium titanium oxide (TiLiₓO_{y}), magnesium titanium oxide (TiMg_{y}Oₓ), or magnesium potassium titanium oxide (TiMgₓK_{y}O_{z}); a metal or metallic layer such as aluminum (Al), aluminum zinc oxide (AlZnO), or titanium nitride (TiN).

Further to the above, a hole injection layer as mentioned above may comprise at least one of the group comprising an p-doped material layer comprising a dopant such as 2,3,5,6-Tetrafluoro-7,7,8,8-tetracyanoquinodimethane (F4-TCNQ) or Dipyrazino[2,3-f:2',3'-h]quinoxaline-2,3,6,7,10,11-hexacarbonitrile (HAT-CN or LG-101); poly-3,4-ethylenedioxythiophene - PEDOT -; a metal oxide such as nickel oxide (NiOₓ) tungsten oxide (WOₓ), molybdenum oxide (MoOₓ); a metal such as silver (Ag) or gold (Au).

In accordance with a further aspect of the present invention there is provided an apparatus for manufacturing a stacked organic light emitting diode (OLED) device, comprising a support unit for supporting a carrier for forming thereon the stacked organic light emitting diode; a first solution printing unit for forming a first organic light emitting diode on the carrier by means of solution printing of consecutive diode layers of said first organic light emitting diode; a thin layer deposition unit for forming one or more charge injection layers on the first organic light emitting diode; and at least one of a second solution printing unit, or a transport unit for providing the carrier back to the first solution printing unit, for forming a second organic light emitting diode on the carrier by means of solution printing of consecutive diode layers of said second organic light emitting diode; wherein the thin layer deposition unit comprises an atomic layer deposition unit for depositing at least one of the one or more charge injection layers by means of an atomic layer deposition step.

In accordance with a further aspect of the present invention is provided a stacked organic light emitting diode device manufactured using the method as described hereinabove.

### Brief description of the drawings

The invention will further be elucidated by description of some specific embodiments thereof, making reference to the attached drawings. The detailed description provides examples of possible implementations of the invention, but is not to be regarded as describing the only embodiments falling under the scope. The scope of the invention is defined in the claims, and the description is to be regarded as illustrative without being restrictive on the invention. In the drawings:
Figure 1 schematically illustrates a method in accordance with an embodiment of the present invention;
Figure 2 schematically illustrates a stacked organic light emitting diode device in accordance with an embodiment of the present invention.

### Detailed description

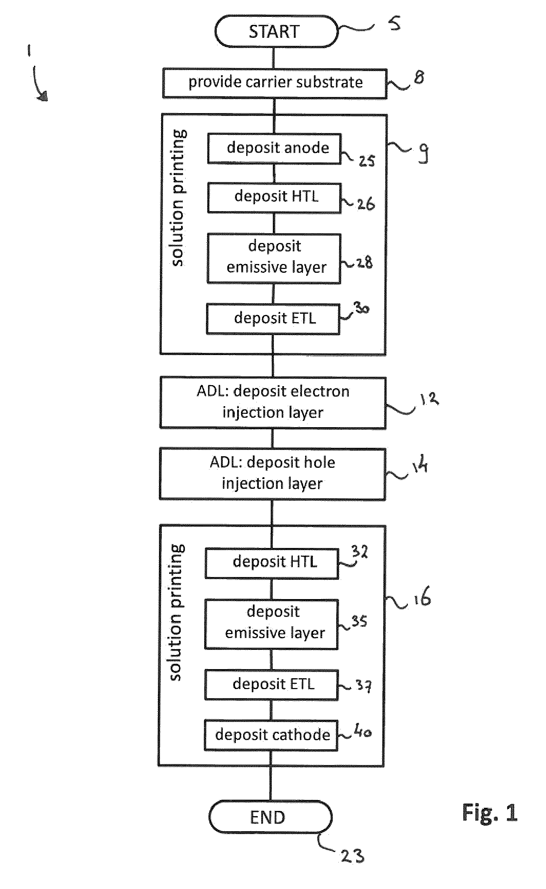

Figure 1 schematically illustrates a method 1 for manufacturing a stacked organic light emitting diode (OLED) device, in accordance with an embodiment of the present invention. In figure 1, the method starts at step 5 and includes a step 8 of providing a carrier substrate for the OLED device to be produced. The carrier substrate provided in step 8 may be any suitable type of substrate for providing an OLED, for example a glass carrier, metal or a polymer. Prior to step 8, any kind of preprocessing step, e.g. manufacturing of the carrier substrate, surface modification of the substrate, or another step, maybe performed. This is not further described herein.

The method 1 in accordance with the present invention consecutively at least comprises the steps of providing a carrier (step 8), the forming of a first organic light emitting diode on the carrier (step 9), the forming of one or more charged injection layers on the first OLED (steps 12 and 14), and the forming of a second OLED (step 16). At least one of these steps, in particular at least one of the steps 12 and 14 of forming the one or more charge injection layers, is performed using an atomic layer deposition method for depositing at least one of the charge injection layers.

In the embodiment illustrated in figure 1, a first OLED is formed in step 9 by the following consecutive steps. On top of the carrier substrate, an anode is deposited in step 25 in the form of a transparent conductor. Then in step 26, a hole transmission layer (HTL) is deposited on top of the anode. There upon, in step 28, there is deposited an emissive layer, and consecutively an electron transport layer (ETL) is deposited in step 30. As illustrated in figure 1, it may be convenient to form the first organic light emitting diode by means of solution printing. Any of the steps 25, 26, 28 and 30 referred to above may be applied as a consecutive solution printing step using suitable printer machines which are fed with the materials that make up each of the consecutive layers. Solution printing may be performed at atmosphere pressure and is therefore particularly useful for industrializing the manufacturing of a stacked OLED device in accordance with the present invention. As will be appreciated, a single printing machine may be used to consecutively print each of the layers in steps 25, 26, 28 and 30. Alternatively, any one or more of the steps 25-30 may be performed by an individual printing machine for solution printing of the respective layer.

When the first OLED device is formed in step 9, one or more charge injection layers are to be created on top of the first OLED. In step 12, an electron injection layer is deposited on top of the electron transport layer (ETL) deposited in step 30. Step 12 is performed, in the embodiment in figure 1, by means of an atomic layer deposition method. Atomic layer deposition may be performed at atmospheric pressure, and has been developed into a deposition technique that may be performed in an industrialized process. For example, the ALD method may be a roll-to-roll type ALD method. In step 14, a hole injection layer is deposited on top of the electron injection layer also by means of atomic layer deposition.

In accordance with the present invention it is advantageous to perform any of the steps 12 or 14 using atomic layer deposition. Alternatively, any of these steps may be performed also by means of solution printing, but in that case the solvent which is used through printing the respective material must be an orthogonal solvent with respect to the layer underneath. The use of atomic layer deposition is advantageous in that it does not require a solvent to be applied, thereby protecting the first OLED that is printed on the carrier substrate against damage from the deposition process. Another advantage of the use of atomic layer deposition is that it allows the use of materials for the charge injection layers that cannot be deposited by means of thermal evaporation due to the temperature to be applied. Atomic layer deposition may be performed at low temperatures (<473k (<200°C)). These temperatures are compatible with low cost plastic substrates like PEN (Polyethylene naphthalate) and PET (Polyethylene terephthalate), and will not damage previously deposited OLED layers. The atomic layer deposition is done at pressures that are somewhat reduced in comparison to atmospheric pressure. This reduced pressure is present inside the deposition head, but the deposition head itself can be placed in an atmospheric pressure environment. Therefore, there is no need to establish a vacuum to perform the ALD method. The manufacturing method as a whole can thus be carried out at moderate temperatures and under atmospheric pressure. This is an important advantage as it allows one to perform the whole manufacturing process in a cost effective manner, making industrialization possible.

After step 14, the method continues with the solution printing of a second organic light emitting diode (second OLED). The forming of the second OLED is illustrated in figure 1 with the consecutive steps 32, 35, 37 and 40. In step 32, a hole transport layer is deposited on top of the hole injection layer that was formed in step 14. Using atomic layer deposition for a step 14, the hole injection layer may be created using a material which is not dissolvable in the solvent used for solution printing for the HTL of the second OLED. Therefore, step 32 will not damage the hole injection layer underneath. In step 35, an emissive layer is deposited by means of solution printing. Thereafter, in step 37 an electrode transport layer is formed and the second OLED is finished by the depositing of a cathode in step 40. The depositing of the cathode may, for example, include anyone of evaporation, sputtering, or solution printing or coating - although it may be appreciated that synergy is achieved by using a method such as solution printing or coating that can be applied at atmospheric pressure. The end of the method 1 in accordance with a first embodiment is indicated with reference numeral 23.

In the above method illustrated in figure 1, the steps 25, 26, 28, 30, 32, 35, 37 and 40 are performed using a solution printing method. It may be appreciated that any one or more of these solution printing steps may be replaced by an atomic layer deposition step as well.

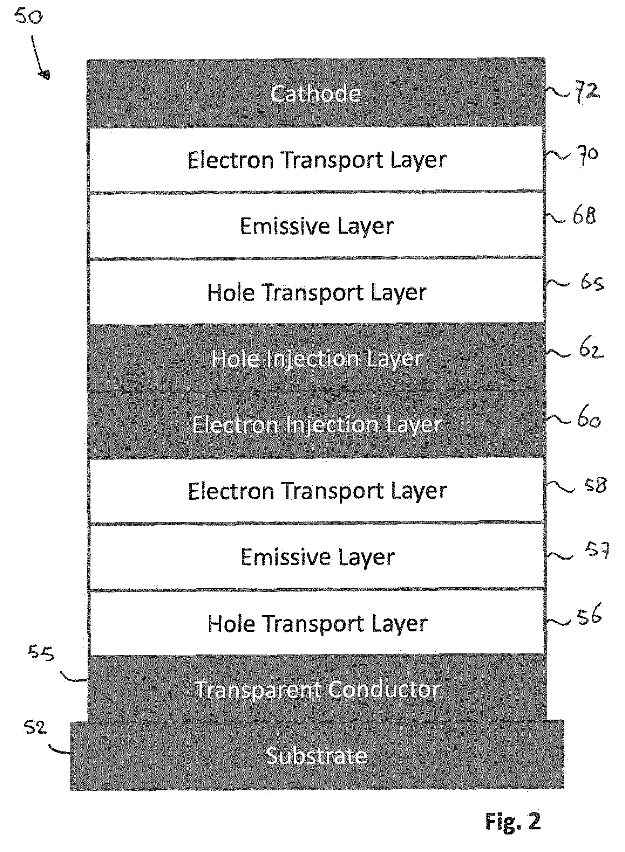

An organic light emitting diode in accordance with the present invention, and created using the method of the present invention, is schematically illustrated in figure 2. The stacked OLED 50 consists of a substrate 52 on top of which a transparent conductor 55 has been deposited.

The carrier substrate 52 may be a glass carrier or a polymer, while the transparent electrode 55 forming the anode may be made of a suitable conductive material such as (but not limited to) indium tin oxide (ITO). On top of the transparent electrode 55, the stacked OLED 50 of the present invention comprises a hole transportation layer (HTL) 56. The hole transportation layer may be made of any suitable material, known to the skilled person. However, in order to enable the application of the hole transportation layer 56 using a solution printing step 26, good candidate materials for the hole transportation layer may be any of the following: arylamines, isoindole, fluorenes, TPD (N,N-diphenyl-N,N-bis(3-methylphenyl)-1,1-biphenyl-4,4-diamine), NPB (1,4-bis(1-naphthylphenylamino)biphenyl), α-NPD (N, N'-di(naphthalen-2-yl)-N, N'-diphenyl-benzidine), m-MTDATA (4,4',4"-tris(3-methylphenylphenylamino) triphenylamine); TCTA (4,4',4"-Tris(carbazol-9-yl)-triphenylamine), 3DTAPBP (2,2'-bis(3-(N,N-di-p-tolylamino)phenyl)biphenyl), TFB (Poly[(9,9-dioctylfluorenyl-2,7-diyl)-co-(4,4'-(N-(4-secbutylphenyl) diphenylamine)]). These examples are provided for illustrative purposes, and are not intended to be limiting on the invention. In between the transparent electrode 55 and the hole transport layer 56, a hole injection layer (not shown) may be present. The hole injection layer may for example comprise poly(3,4-ethylenedioxythiophene)-tetramethacrylate (PEDOT-TMA) or poly(3,4-ethylenedioxythiophene) poly(styrenesulfonate) (PEDOT-PSS).

On top of the HTL 56, an emission layer 57 is provided using again a solution printing process, e.g. step 28. A suitable choice of materials for providing the emission layer is known to the skilled person, however some examples are provided herewith for illustrative purposes only: metal chelates, such as Alq3 (tris(8-hydroxyquinoline) aluminium), Ir(ppy)3 (factris(2-phenylpyridine) iridium) in CPB (4,4-N,N-dicarbazole-biphenyl), FIrPic (Bis(3,5-difluoro-2-(2-pyridyl)phenyl-(2-carboxypyridyl)iridium(III)) in DCzPPy (2,2'-bis(3-(N,N-di-p-tolylamino)phenyl)biphenyl), or Ir(pic)3 (Tris(1-phenylisoquinoline)iridium(III)); materials having an anthracene structure, a pentancene structure or a Perylene structure; and silanes. These examples are not intended to be limiting on the invention.

On top of the emission layer, the stacked OLED 50 of the present invention comprises a electron transport layer (ETL) 58, also created by means of a solution printing step , e.g. step 30. The electron transport layer (ETL) 58 may be suitably selected by the skilled person from known alternatives, such as: ETLs (e.g. diazoles, boranes, phenanthrolines, carbazoles, pyridyls), BCP bathocuproine (2,9-dimethyl-4,7-diphenyl-1.10-phenanthroline), TPBI (1,3,5-tris(N-phenylbenzimidizol-2-yl)benzene), BmPyPhB (1,3,5-tri [(3 -pyridyl)phen- 3 -yl] benzene (TmPyPB), 1,3-bis[3,5-di(pyridine-3-yl)phenyl]benzene (BmPyPhB)), and combinations thereof. These examples are provided for illustrative purposes, and are not intended to be limiting on the invention.

In accordance with the present invention, on top of the electron transport layer 58, an electron injection layer 60 is deposited by means of atomic layer deposition in step 12. The electron injection layer may comprise an n-doped material layer comprising a dopant such as an amine, a conjugated organic dopant, a metal salt, or a low work function metal such as cesium, lithium or magnesium, a metal oxide such as zinc oxide (ZnOₓ), titanium oxide (TiOₓ), aluminum zinc oxide (AlZnₓO_{y}), lithium zinc oxide (ZnLiₓO_{y}), magnesium zinc oxide (ZnMgyOₓ), lithium titanium oxide (TiLiₓO_{y}), magnesium titanium oxide (TiMg_{y}Oₓ), or magnesium potassium titanium oxide (TiMgₓK_{y}O_{z}); a metal or metallic layer such as aluminium (Al), aluminium zinc oxide (AlZnO) or titanium nitride (TiN).

The hole injection layer 62 may be deposited by means of atomic layer deposition step 14. The hole injection layer may comprise at least one of the group comprising an p-doped material layer comprising a dopant such as 2,3,5,6-tetrafluoro-7,7,8,8-tetracyanoquinodimethane (F4-TCNQ) or dipyrazino[2,3-f:2',3'-h]quinoxaline-2,3,6,7,10,11-hexacarbonitrile (HAT-CN or LG-101); poly-3,4-ethylenedioxythiophene-PEDOT -; a metal oxide such as nickel oxide (NiOₓ) tungsten oxide (WOₓ), molybdenum oxide (MoOₓ); a metal such as silver (Ag) or gold (Au).

The advantage of using an atomic layer deposition has been indicated hereinabove such as to protect the first organic light emitting diode layers underneath. On top of the hole injection layer 62, a second organic light emitting diode layer may be deposited consisting again of a hole transport layer (HTL) 65, an emissive layer (68) and an electron transport layer 70. The HTL 65, emissive layer 68 and ETL 70 may be comprised of the same materials that were also used for the first OLED such as to increase the light yield in the same spectral bandwidth. As will be appreciated, if desired by the skilled person, different materials may be used such as to target a different emission spectrum.

In accordance with the embodiment illustrated in figure 2, a cathode layer 72 is deposited on top of the electron transport layer 70. The cathode may be made of any suitable conductive material such as a metal or the like.

Instead of immediately depositing the cathode of the device, any number of further organic light emitting diodes (e.g. a third OLED, fourth OLED, or fifth OLED) may be created on top of the second OLED. In between each two OLED of the stacked OLED, charge injection layers such as electron injection layers 60 and hole injection layer 62 are to be created such as to allow interconversion of electrons and holes in between each two subsequent OLEDs. The OLEDs created on top of each other may be of a same or different emission spectrum as mentioned above.

An apparatus for performing the method of the present invention and for creating an OLED stack in accordance with the present invention, may consist of one or more solution printing machines and at least one atomic layer deposition apparatus. As already mentioned above, each of the solution printed layers may be printed using an individual printing machine. The use of a separate printing machine for each of the consecutive layers prevents these layers from being polluted by any materials that may undesirably retain in a printing machine of a previous layer. On the other hand, in case only small numbers of stacked OLEDs are to be produced, the use of a single printing machine with a purging method for cleaning the printing heads may economically be a more attractive solution. In case the stacked OLEDs are to be produced in large numbers, the use of individual printing machines for each of the materials to be deposited could be advantageous in view of the above.

As mentioned, the method can be performed at atmospheric pressure (or at a different pressure if this would be desired), and at regular ambient or moderate temperatures (e.g. 293k, or < 480k). Dependent on the chemical process, temperatures may also be elevated or lowered by the skilled person. Typical temperatures for performing ALD may be 270k to 900k (e.g. ∼0°C to 650°C), for example 293k (20°C), 373k (100°C), 473k (200°C), 493k (220°C), 573k (300°C), 673k (400°C), 773k (500°C).

The present invention has been described in terms of some specific embodiments thereof. It will be appreciated that the embodiments shown in the drawings and described herein are intended for illustrated purposes only and are not by any manner or means intended to be restrictive on the invention. The context of the invention discussed here is merely restricted by the scope of the appended claims.

## Claims

1. Method of manufacturing a stacked organic light emitting diode - OLED-device, comprising the steps of:
providing a carrier;
forming a first organic light emitting diode on the carrier by means of solution based depositing of consecutive diode layers of said first organic light emitting diode;
forming one or more charge injection layers on the first organic light emitting diode;
forming a second organic light emitting diode on the carrier by means of solution based depositing of consecutive diode layers of said second organic light emitting diode;
wherein the step of forming of the one or more charge injection layers comprises a step of performing atomic layer deposition for depositing at least one of the one or more charge injection layers.

2. Method according to any of the previous claims, wherein the method are performed at atmospheric ambient pressure.

3. Method according to any of the previous claims, wherein the step of forming of the one or more charge injection layers comprises at least one of a step of forming of an electron injection layer or a step of forming of a hole injection layer.

4. Method according to claim 3, wherein the step of forming of the one or more charge injection layers comprises a step of forming of an electron injection layer, wherein the electron injection layer comprises at least one of a group comprising: an n-doped material layer comprising a dopant such as an amine, a conjugated organic dopant or a metal salt; a metal oxide such as zinc oxide (ZnOₓ) or titanium oxide (TiOₓ), aluminum zinc oxide (AlZnₓO_{y}), lithium zinc oxide (ZnLiₓO_{y}), magnesium zinc oxide (ZnMg_{y}Oₓ), lithium titanium oxide (TiLiₓO_{y}), magnesium titanium oxide (TiMg_{y}Oₓ), or magnesium potassium titanium oxide (TiMgₓK_{y}O_{z}); a metal or metallic layer such as aluminum (Al), aluminum zinc oxide (AlZnO), or titanium nitride (TiN); or a low work function metal such as cesium, lithium or magnesium.

5. Method according to any of claims 3 or 4, wherein the step of forming of the one or more charge injection layers comprises a step of forming of a hole injection layer, wherein the hole injection layer comprises at least one of a group comprising: an p-doped material layer comprising a dopant such as 2,3,5,6-tetrafluoro-7,7,8,8-tetracyanoquinodimethane (F4-TCNQ) or dipyrazino[2,3-f:2',3'-h]quinoxaline-2,3,6,7,10,11-hexacarbonitrile (HAT-CN or LG-101); poly-3,4-ethylenedioxythiophene-PEDOT -; a metal oxide such as nickel oxide (NiOₓ) tungsten oxide (WOₓ), molybdenum oxide (MoOₓ); a metal such as silver (Ag) or gold (Au).

6. Method according to any of the claims 3-5, wherein at least one or both of said steps of forming of an electron injection layer or forming of a hole injection layer comprises said atomic layer deposition for providing said electron injection layer or hole injection layer.

7. Method according to any of the previous claims, wherein the atomic layer deposition step is a roll-to-roll type atomic layer deposition step.

8. Method according to any of the previous claims, wherein at least one of the solution based depositing of consecutive diode layers of said first organic light emitting diode, or the solution based depositing of consecutive diode layers of said second organic light emitting diode, comprises at least one of a group comprising solution printing or solution coating of one or more of said consecutive diode layers.

9. Apparatus for manufacturing a stacked organic light emitting diode-OLED - device, comprising
a support unit for supporting a carrier for forming thereon the stacked organic light emitting diode ,
a first solution based depositing unit for forming a first organic light emitting diode on the carrier by means of solution based depositing of consecutive diode layers of said first organic light emitting diode;
a thin layer deposition unit for forming one or more charge injection layers on the first organic light emitting diode; and
at least one of a second solution based depositing unit, or a transport unit for providing the carrier back to the first solution based depositing unit, for forming a second organic light emitting diode on the carrier by means of solution based depositing of consecutive diode layers of said second organic light emitting diode;
wherein the thin layer deposition unit comprises an atomic layer deposition unit for depositing at least one of the one or more charge injection layers by means of an atomic layer deposition step.

10. Apparatus according to claim 9, wherein at least one of the first or second solution based depositing unit includes at least one of a group comprising a solution printing unit or a solution coating unit.

11. Stacked organic light emitting diode device manufactured using a method in accordance with any of the claims 1-8, or using an apparatus in accordance with claim 9 or 10.
